# EUROPEAN PATENT SPECIFICATION

(11) **EP 0 920 114 B1**
(45) Date of publication and mention of the grant of the patent: **17.02.2010**
(21) Application number: 98921779.9
(22) Date of filing: 22.05.1998
(51) Int. Cl.: H02M 1/06, H02M 1/08

(54) **POWER CONVERTER WHEREIN MOS GATE SEMICONDUCTOR DEVICE IS USED**
STROMWANDLER MIT MOS-GATE-HALBLEITERANORDNUNG
CONVERTISSEUR DE PUISSANCE METTANT EN APPLICATION UN COMPOSANT A SEMI-CONDUCTEUR DE PORTE MOS

(30) Priority: 23.05.1997 JP 13318197
(43) Date of publication of application: 02.06.1999
(73) Proprietor: KABUSHIKI KAISHA TOSHIBA, Kawasaki-shi, Kanagawa-ken 210-8572 (JP)
(72) Inventor: HOSHI, Kimihiro, Tokyo 184-0014 (JP); IWANO, Yoshinori, Yokohama-shi Kanagawa-ken 236-0052 (JP); NAKAYAMA, Kazuya, Kanagawa-ken 228-0827 (JP)
(74) Representative: Henkel, Feiler & Hänzel
(86) International application number: PCT/JP1998/002267
(87) International publication number: WO 1998/053546

(56) References cited:
- EP-A- 0 420 582
- EP-A- 0 645 889
- JP-A- 3 065 046
- JP-A- 5 336 732
- JP-A- 7 177 727
- US-A- 5 204 563

## Description

### Technical Field

The present invention relates to a power converting apparatus using semiconductor elements of MOS gate type such as IGBTs (Insulated Gate Bipolar Transistors) and IEGTs (Injection Enhanced Gate Transistors), and more particularly using high-voltage, large-current power elements.

### Background Art

The withstand voltages of semiconductor elements, represented by IGBTs, have increased. Recently, IGBTs having a high withstand voltage of 1.7 kV or 2.5 kV have put to commercial use. More recently, new elements having higher withstand voltages, such as IGBTs having a withstand voltage of 3.3 kV and IEGTS having a withstand voltage of 4.5 kV, have been developed.

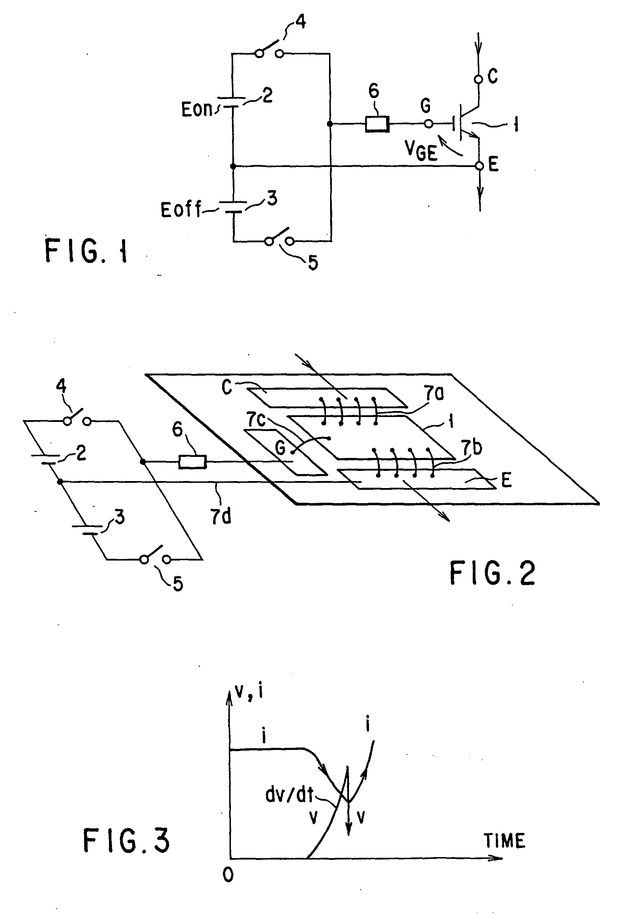

A conventional power converting apparatus using a MOS gate type semiconductor element having such a high withstand voltage will be described, with reference to FIGS. 1 to 3. As shown in FIG. 1, a series circuit composed of a power supply 2 for applying a on-gate voltage Eon (usually +15V) and an on switch 4, and a series circuit composed of a power supply 3 for applying an off-gate voltage Eoff and an off switch 5 are connected between the gate and emitter of an IEGT 1 by a gate resistor 6 which serves for both on operation and off operation. The IEGT 1 is turned on and a current flows through it when the switch 4 is closed, applying the on-gate voltage Eon on the gate and emitter of the IEGT 1 through the gate resistor 6. To cut off the current, the switch 5 is closed, applying the off-gate voltage Eoff between the gate and emitter of the IEGT 1 through the gate resistor 6. The IEGT 1 is thereby turned off, cutting off the current.

The wiring of a module type element including an IEGT 1 will be described with reference to FIG. 2, in which the components identical to those shown in FIG. 1 are designated at the same reference symbols. As shown in FIG. 2, the IEGT 1 is connected to a collector terminal C by a plurality of collector wires 7a (four conductors as shown in the drawing), to an emitter E by a plurality of emitter wires 7b (four conductors as shown in the drawing), and to a gate terminal G by a gate wire 7c. Symbol 7d denotes an emitter wire for the gate.

FIG. 3 shows the waveforms of the voltage and current applied and supplied to the IEGT 1 when the current is cut off in the circuit illustrated in FIG. 1. When the current i is cut off, the voltage v applied to the IEGT 1 abruptly rises as the current i decreases. Ultimately, the voltage v may break the IEGT 1 down.

When the current was cut off during experiment conducted on the conventional power converting apparatus, however, dv/dt was very large, breaking down the element.

This is because dv/dt applied to the IEGT increases when the IEGT is turned off, greatly increasing the power which the element consumes and which is a product of the voltage applied to the element and the cut off current.

There is the trend, the greater the cut-off current applied for the same voltage, the larger the value of dv/dt. This renders it more likely that the element would be broken down.

The trend is, the higher the withstand voltage of the element, the greater the gate capacitance thereof. In the case of a multi-chip element, the difference in turn-off delay time between the chips becomes large. As a consequence, the current balance between the chips deteriorates at the time the element is turned off.

The object of the present is to provide a power converting apparatus in which no excessive dv/dt is applied to any element and no current flows concentratedly in some of the elements, thus preventing breakdown of the element, and which can cut off a large current such as an accidental current.

US-A-5 204 563 discloses a power converting apparatus comprising a MOS gate type semiconductor element section, on-voltage applying section for applying an on-voltage between the gate and emitter terminals of the MOS gate type semiconductor element section, and an off-voltage applying section for applying an off-voltage between the gate and emitter terminals of the MOS gate type semiconductor element section. Additionally, an inductance element is provided so as to be connected with a MOS gate type semiconductor element.

On the other hand EP-A-0 645 889 discloses a similar circuit arrangement where additionally a diode is connected parallel to the semiconductor element section for protection reasons.

### Disclosure of Invention

According to the present invention the above object is achieved by a power converting apparatus according to claim 1 or claim 2. The dependent claims are directed to different advantageous aspects of the present invention.

### Brief Description of Drawings

FIG. 1 is a circuit diagram of a conventional apparatus;
FIG. 2 is a wiring diagram of the conventional apparatus;
FIG. 3 is a diagram showing the voltage and current waveforms of the conventional apparatus;
FIG. 4 is a circuit diagram of a part of the apparatus according a first embodiment of the present invention;
FIG. 5 is a wiring diagram of a part of the apparatus according the first embodiment of the invention;
FIG. 6 is a diagram showing the voltage and current waveforms of the conventional apparatus;
FIGS. 7A to 7C are diagrams showing a part of an apparatus according to a second embodiment of the invention;
FIG. 8 is a circuit diagram of an apparatus according a third embodiment not covered by the invention;
FIG. 9 is a circuit diagram of an apparatus according a fourth embodiment not covered by the invention;
FIGS. 10A to 10C are diagrams showing a part of an apparatus according to a fifth embodiment of this invention;
FIGS. 11A to 11C are diagrams showing a part of an apparatus according to a sixth embodiment of the present invention;
FIGS. 12A and 12B are diagrams showing the voltage and current waveforms of the apparatuses according to the fifth and sixth embodiments of the invention;
FIG. 13 is a circuit diagram of a part of an apparatus according a seventh embodiment of the invention;
FIG. 14 is a circuit diagram of a part of an apparatus according an eighth embodiment of this invention;
FIGS. 15A and 15B are diagrams showing the voltage and current waveforms of an apparatuses according to a ninth embodiment of the invention;
FIG. 16 is a circuit diagram of the apparatus according the ninth embodiment not covered by the invention; and
FIG. 17 is a circuit diagram of a part of an apparatus according a tenth eighth embodiment of the present invention.

### Best Mode of Carrying Out the Invention

The invention is a power converting apparatus as defined in claims 1 or 2. In the following embodiments not always all features of the invention are discussed. However a skilled person will recognize that the invention requires all elements mentioned in the independent claims.

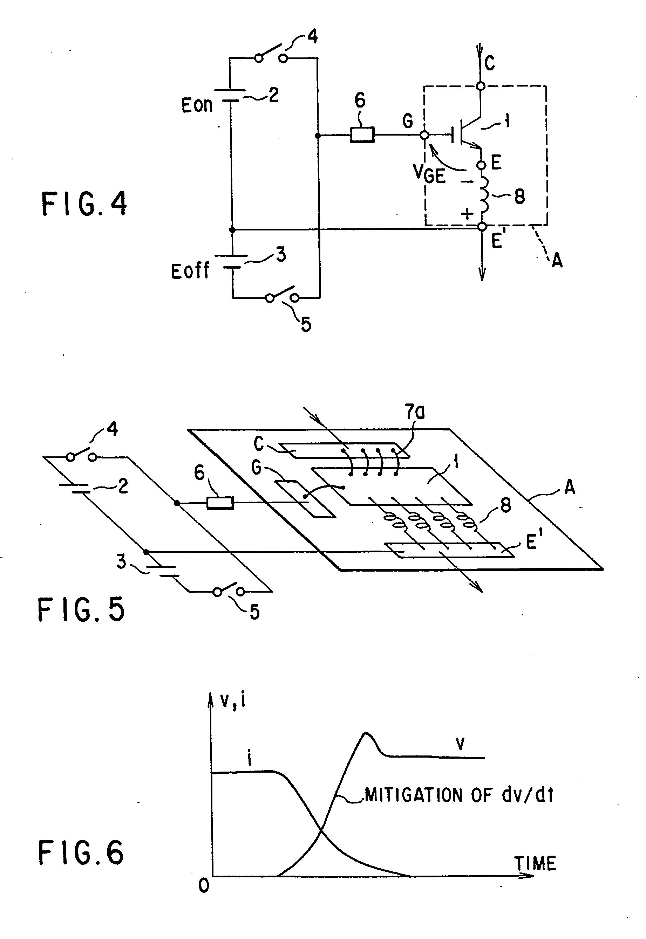

The first embodiment of this invention will be described below, with reference to FIGS. 4 to 6. The components shown in the following drawings, which are the same as those shown in FIGS. 1 to 3 showing the conventional apparatus, perform the same functions.

Part A indicated by broken lines in FIG. 4 is a module type element according to the invention, which has a MOS gate type chip such as an IGBT or an IEGT. The same holds true of any other embodiment that will be described later.

As shown in FIGS. 4 and 5, the IEGT 1 and an emitter terminal E' are connected by inductance elements 8 in the present embodiment. As shown in these figures, the inductance element 8s are a plurality of coils (four coils are shown in the figures).

Since the inductance elements 8 are inserted as shown in FIG. 4, a voltage L*di/dt is generated in the inductance elements 8 when the current is cut off. The gate voltage Vge actually applied to the IEGT 1 is therefore not Eoff, but is decreased to (Eoff - L*di/dt). Thus, the turn-off voltage is mitigated.

As a result, a cutoff phenomenon will not develop fast, and dv/dt is mitigated at the time of tuning off. The advantage that no breakdown of the element takes place is therefore achieved.

Further, di/dt becomes even greater when a large current is cut off, because the inductance elements 8 are inserted. The off gate voltage therefore decreases, mitigating dv/dt and preventing the breakdown of the element. The value of the voltage can be automatically corrected, thereby to prevent the breakdown of the element at the time of turn-off.

As shown in FIG. 5 illustrating the arrangement of bonding wires, a collector-side wire 7a is made shorter than the inductance elements 8 that serve also as emitter-side wires. This increases the ratio of the total length of the inductance elements 8 to the total length of all wires, assuming that the total length of all wires remains the same. The advantage of incorporating the inductance elements 8 into the module type element is thereby enhanced further.

It is desired that the inductance elements 8 have a total inductance of 50 nH or less, for the reason given below.

First, a maximum withstand voltage is applied to the gate of the IEGT. When an additional voltage is applied to the gate, dielectric breakdown occurs. Generally, the gate withstand voltage of a MOS gate type semiconductor element should be suppressed to 100V or less. In a high-voltage element such as an IEGT, the cutoff current di/dt is usually 200A/µs. Hence, inductance L = 100V/(di/dt) = 100V/200A/µs = 500 nH. Thus, if the inductance L is set to have this value or a smaller value, the dielectric breakdown of the gate can be prevented.

The gate voltage is about 15V. In view of this, the voltage corrected by the inductance, namely L*di/di, should be suppressed to 10V or less. Hence, L = 10V/di/dt = 10V/200A/µs = 50 nH. What satisfies both 500 nH and 50 nH is 50 nH.

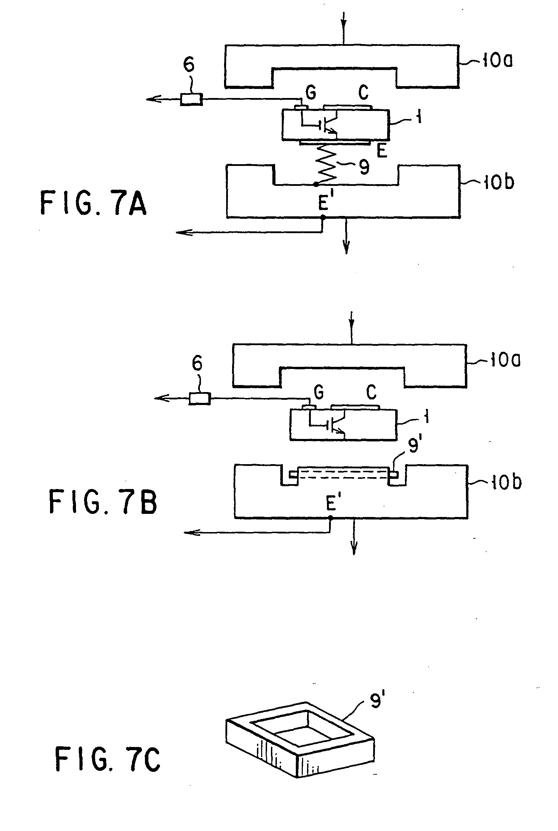

The second embodiment of the invention and a modification of the second embodiment will be described, with reference to FIG. 7A and FIG. 7C. The embodiment shown in FIG. 7A is a piezoelectric element having a pressure-contact semiconductor chip. An IEGT 1 is set in press-contact in a space between the package members 10a and 10b of a pressure-contact package 10. Having almost no inductance elements, the IEGT of press-contact type has even greater dv/dt than the wire-bonding type chip of the first embodiment. The element is more likely to be broken down.

In the present embodiment, the chip terminal E of the IEGT 1 and the terminal E' of the press-contact element are connected by an inductance element 9 shaped like a spring. Since the inductance element 9 is so connected to the emitter terminal, the increase in dv/dt, occurring at the time of turning off, can be mitigated to prevent the breakdown of the element.

In the embodiment shown in FIGS. 7B and 7C, an annular inductance element (reactor) 9' shown in FIG. 7C is used in place of the spring-shaped inductance element 9 used in the embodiment shown in FIG. 7A. The inductance element 9' is arranged, passing through the emitter-side terminal of the pressure-contact type element.

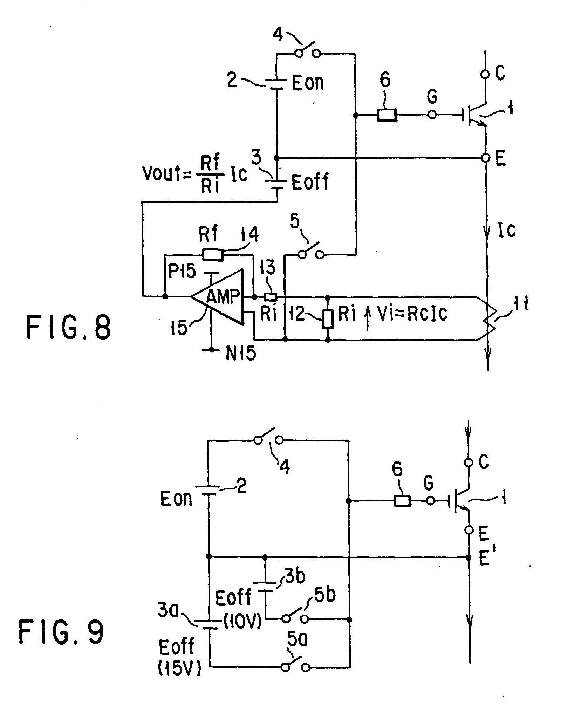

The third embodiment, which is not part of the invention, will be described with reference to FIG. 8.

Generally, a method of preventing the breakdown of an element, despite the increase in dv/dt, other than the use of the above-mentioned inductance element, may be employed. This method is to increase the gate power-supply voltage gradually, not applying a high voltage.

Therefore, a CT (Current Transformer) 11 is used in the embodiment of Fig. 8. The CT 11 is connected to a line led from the emitter terminal of an IEGT 1, for detecting the current. Further, a power amplifier 15 for receiving the output of the CT 11 and the outputs of resistors 12 to 14 is incorporated in the series circuit composed of an off switch 5 and a power supply 3 that applies an off-gate voltage Eoff.

In this structure, the CT 11 detects the current that should be cut off, and the input resistor 13, feedback resistor 14 and power amplifier 15 cooperate, generating an output Vout = (R14/R13)(R1). Hence, the off voltage applied to the gate becomes Eoff - Vout.

As a result, in this method other than the method of using an inductance element to achieve mitigation of dv/dt, no high voltage is applied as the off gate voltage when the current is large. Therefore, an abrupt dv/dt is not generated at the time of turning off. The breakdown of the element can therefore be prevented.

The fourth embodiment, which is not part of the invention, will be described with reference to FIG. 9. In this embodiment, a circuit is connected to a gate terminal G and an emitter terminal E; it is provided, replacing the series circuit which is shown in FIG. 4 and which comprises the power supply 3 for applying the off-gate voltage Eoff and the off switch 5. The circuit comprises two series circuits. The first series circuit comprises a power supply 3a for applying an off-gate voltage Eoff and an off switch 5a. The second circuit comprises a power supply 3b for applying an off-gate voltage Eoff and an off switch 5g.

The power supply 3a of the first series circuit applies, for example, -15V. The power supply 3b of the second series circuit applies -10V.

In the embodiment of Fig. 9, the power supply of -15V is not used at first to apply the gate voltage, and the voltage of the power supply 5b of -10V is applied after the switch 5b has been closed to turn off the element. Hence, a high dv/dt is not generated, and there is no possibility that the element will be broken down. After the element is turned off, the switch 5b is opened to prevent erroneous turn-on of the IEGT 1. Then, the switch 5a is closed, thereby applying -15 of the power supply 3a.

Thus, a simple gate circuit can mitigate the vd/vt can be mitigated at the time of turning off. Although the third and fourth embodiments do not belong to the invention the corresponding description helps to understand the invention as defined in the claims.

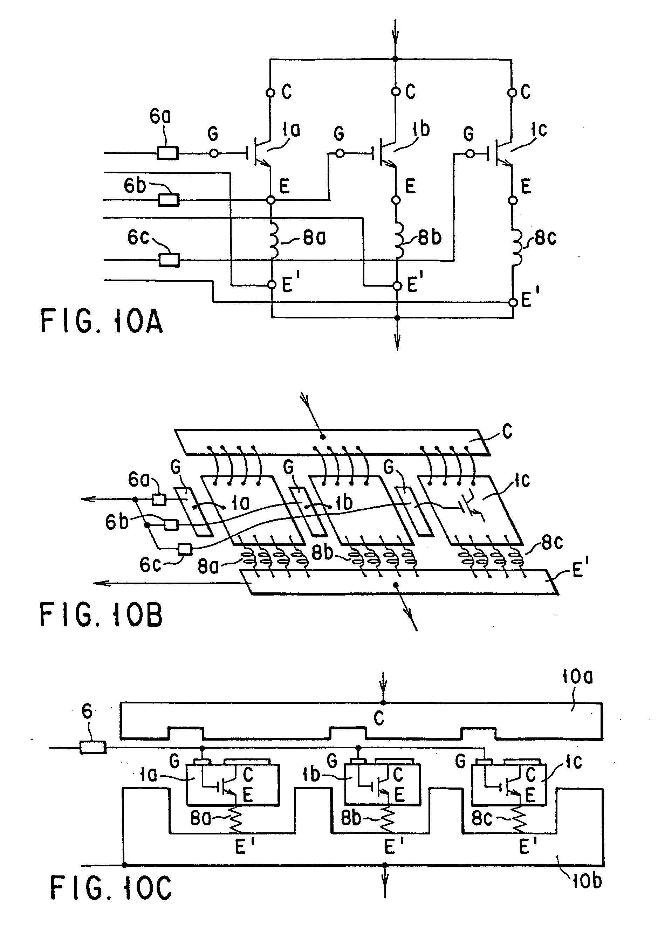

The fifth and sixth embodiments of this invention will be described, with reference to FIGS. 10A to 10C, FIGS. 11A to 11C, FIGS. 12A and 12B, and FIG. 13. The fifth embodiment shown in FIG. 10A has three IEGTs 1a, 1b and 1c connected in parallel. The emitter terminals E of the IEGTs 1a, 1b and 1c are connected to three module emitter E' by inductance elements 8a, 8b and 8c, respectively. Each of the inductance elements 8a, 8b and 8c comprises a plurality of coils (four coils, as shown in the figure).

With this structure, the currents in the IEGTs 1b and 1c decrease when the IEGTs 1b and 1c start cutting off the currents. The remaining part of all current therefore flows concentratedly in the IEGT 1a. As a result of this, the gate voltages of the IEGTs 1b and 1c change to Eoff - L(di2/dt) and Eoff - L(di3/dt), respectively. Namely, the gate voltages for cutting off the currents decreases.

Meanwhile, the gate voltage of the IEGT 1a changes to Eoff + L(di/dt). That is, the gate voltage for cutting off the current increases. Thus, in the IEGT 1a, the power (V_{GE}+L*di/dt) for cutting off the current immediately increases even if the current starts concentrating. In the IEGT 1b and 1c, the power (V_{GE}-L*di/dt) for cutting off the current decreases. The cutoff current of the IEGT 1a is therefore balanced with the cutoff current of the IEGT 1b and also with the cutoff current of the IEGT 1c.

As indicated above, the IEGTs connected in parallel are balanced in terms of cutoff current in the present embodiment. The embodiment can, as a whole, can cut off a large current.

This advantage is attained not only for an element which may be broken down if the dv/dt is high at the time of turn-off as in the first embodiment. It is attained also for the conventional IGBT of low withstand voltage which is not designed to operate well in spite of dv/dt at the time of turn-off. Namely, the balance of currents is improved in the IGBT, too.

If the element is broken down because the dv/dt is high at the time of turn-off, this inductance element will improve not only the cutoff frequency ability of one IEGT, but also the balance of currents in the case where elements are connected in parallel. As a whole, the inductance element can serve to improve the cutoff frequency ability.

FIG. 10B shows a plurality of IEGTs 1, which are wire-bonding type chips and incorporated in a module package. The bonding wires may be made short at the collector side and long at the emitter side. If so, the advantage of the present embodiment will be greater than otherwise.

In the case bonding wires of the type shown in FIG. 10B cannot provide sufficient inductance, a small reactor 8 of the type shown in FIG. 10A may be provided, in place of the bonding wires of the type shown in FIG. 10B, thereby to provide required inductance.
FIG. 10C shows a plurality of IEGTs 1, which are press-contact chips, connected in parallel and incorporated in a press-contact (planar) package.

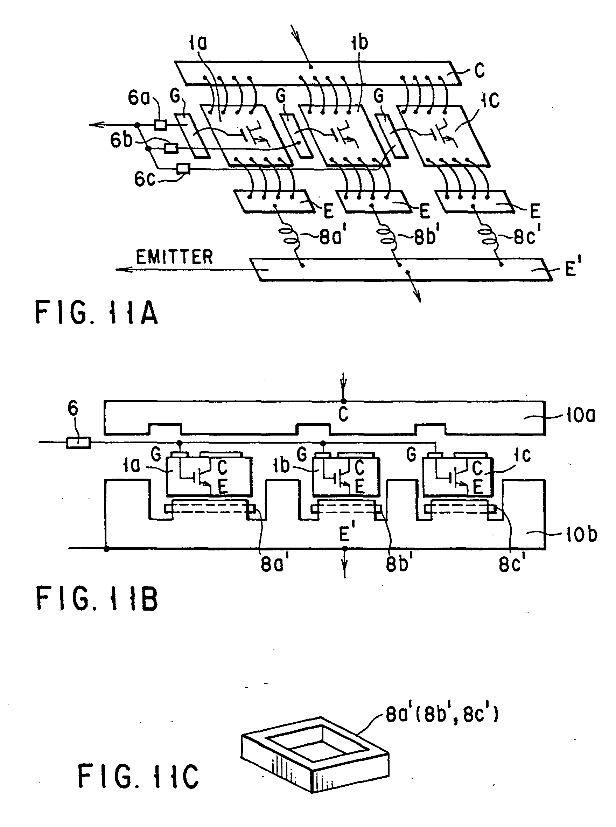

FIG. 11B shows another type of an apparatus, in which a plurality of IEGTs 1, or press-contact chips, are connected in parallel. Reactors 8' are cores. The emitter terminal E' has ends which project toward the IEGTs 1. The annular reactors 8' of the type shown in FIG. 11C are mounted around the projecting ends of the emitter E', practically providing the circuit illustrated in FIG. 11A.

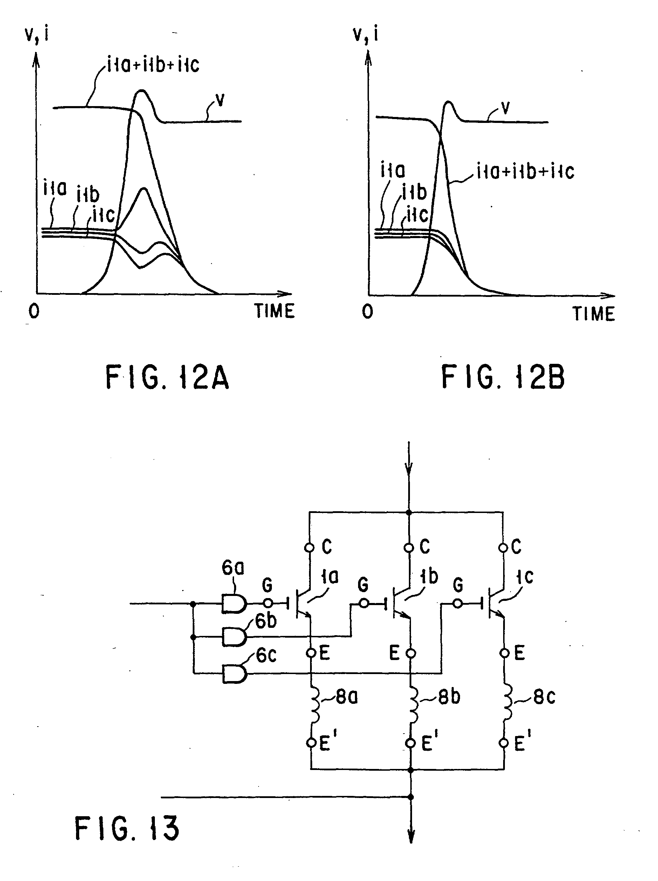

In the case where no circuit according to the invention is used (in a conventional apparatus), the current-voltage characteristic of each IEGT becomes unbalanced at the time of turn-off, as is illustrated in FIG. 12A. In the present embodiment, it becomes better balanced as is depicted in FIG. 12B.

In the embodiments described above, three elements are connected in parallel. Nonetheless, the same advantage can be attained if more elements are connected in parallel.

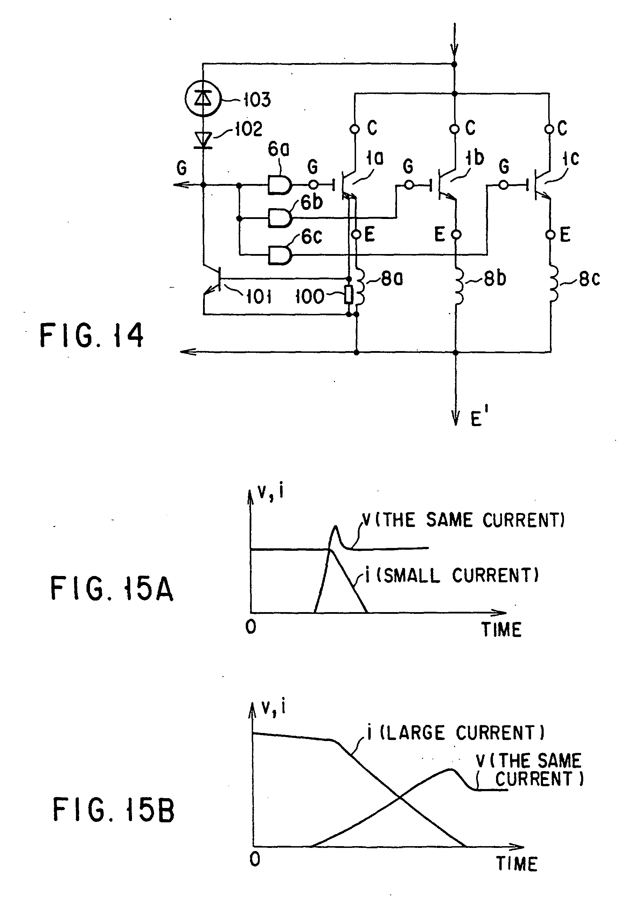

The seventh embodiment of the present invention will be described with reference to FIG. 13. As shown in FIG. 13, the gate resistors 6a, 6b and 6c of IEGTs 1 of the type shown in FIG. 10 are connected in a different way, thereby simplifying the wiring of the gate circuits. FIG. 14 illustrates the eighth embodiment, in which the present invention is applied to protection against an excessive voltage and an excessive current, achieved by gate control. More specifically, when an excessive voltage is applied to the IEGT 1a, for example, a constant-voltage diode 103 and a diode 102 turn-on the IEGT 1a, suppressing the excessive voltage. Gate-control protection is thereby accomplished. Protection against an excessive current is performed by a current sensor, i.e., a resistor 100, connected to, for example, the IEGT 1a. That is, the resistor 100 detects an excessive current, causing a transistor 101 to lower the gate potential of the IEGT 1a, whereby the excessive current is suppressed. Gate-control protection is thus accomplished.

In an element incorporating circuits for achieving such gate-control protection against an excessive voltage and an excessive current, the gate potentials of the chips come to differ during the protection. Consequently, the currents in the chips are likely to become unbalanced with one another. In the present embodiment, the currents in the chips can be balanced well because the reactors 8 control the gate voltages of the chips.

The ninth embodiment of this invention will be described with reference to FIG. 15A, FIG. 15B and FIG. 15C. In the case of a conventional low-voltage IGBT or the like, di/dt greatly changes at the time of turn-off, depending on the value of the on-gate resistance. The change of di/dt is related to the time delay of the turn-off phenomenon, but the waveform of the voltage and the waveform of the current scarcely change at the time of turn-off.

In an element having a high withstand voltage, such as an IEGT, however, the current that can be cut off greatly changes with the value of the off-gate resistance. An IEGT has specific characteristics. As shown in FIG. 15A, the voltage and current change greatly and the switching loss is small if the off-gate resistance is low, but the current that can be cut off decreases. Conversely, if the off-gate resistance is high, the switching loss is large but the current that can be cut off can be large, as is illustrated in FIG. 15B.

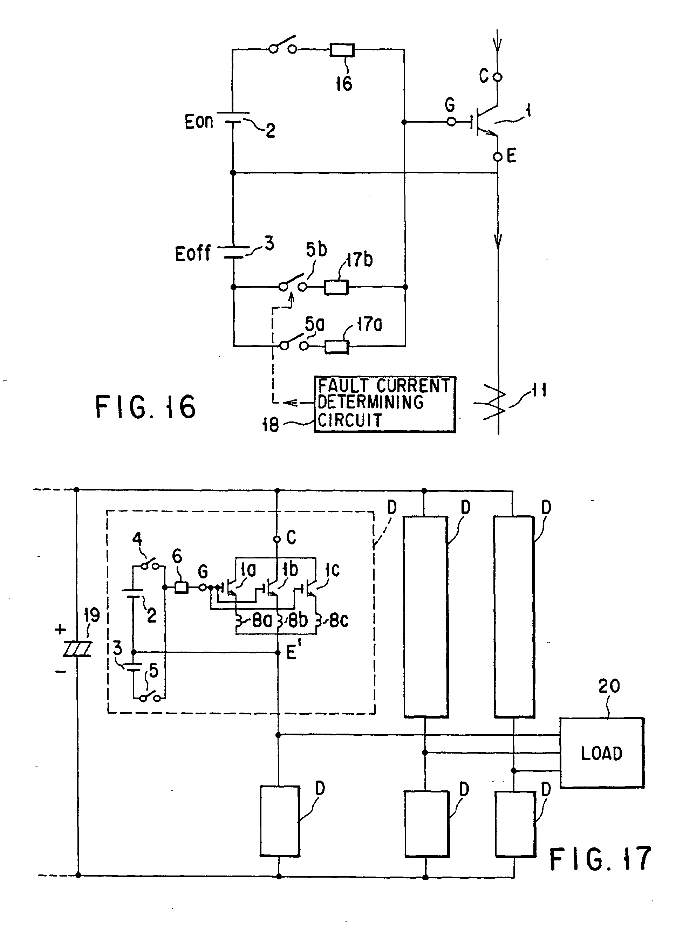

FIG. 16 shows an embodiment, which does not from part of the invention, in which a plurality of off-gate resistors are provided to make it possible to select a value for the current that can be cut off, from various values. This embodiment utilizes the above-mentioned characteristics of an IEGT in order to accomplish protection against a large current that may flow when the upper and lower arms of an inverter or the like are short-circuited.

As shown in FIG. 16, a CT 11 for detecting a fault current is connected to the line lead from the emitter terminal of an IEGT 1. The output of the CT 11 is supplied to a fault current determining circuit 18. Off switches 5a and 5b and resistors 17a and 17b are connected between the gate terminal of the IEGT 1 and a power supply 3 for applying off-gate voltage Eoff. The off switches 5a and 6b are controlled, either turned on or turned off, by the fault current determining circuit 18.

In this structure, the fault current determining circuit 18 usually closes the switch 5a, and the resistor 17a having a high resistance is thereby used as off-gate resistance.

Thus, a large current such as a fault current can be safely cut off. Since a fault current is one that should not be cut off many times, it will not cause the breakdown of the element or affect the inverter loss even if the switching loss is large.

The tenth embodiment of the present invention will be described with reference to FIG. 17.

This embodiment is different from the embodiment shown in FIGS. 10A to 10C or the embodiment shown in FIGS. 11A to 11C, in that six circuits of the type D (i.e., the circuit shown in FIG. 4) are connected, forming a bridge. The bridge circuit is connected between a dc capacitor 19 and a load 20, thereby constituting a three-phase inverter.

In the present embodiment, the cut-off current of each IEGT increases, improving the current balance between the chips even more. The cut-off currents of MOS gate type semiconductor elements can be large. The embodiment can therefore be a power converting apparatus that has a large capacitance.

This embodiment is a three-phase inverter. Nevertheless, it may be any other type of a power converting apparatus that uses MOS gate semiconductor elements, such as a pulse power supply, a dc power supply, a resonant power converting system, or a chopper circuit. Whichever power converting apparatus it may be, the present embodiment attains the same advantages.

IEGTs have been described as an example of a MOS gate semiconductor element. Nonetheless, the present invention can be applied to any other type of an element that may be broken down due to dv/dt generated at the time of turn-off, such as IGBT which has a high withstand voltage or IGBT whose cut-off current is changed 10% or more by a gate resistance.

### Industrial Applicability

As has been described above, the present invention can provide a power converting apparatus in which neither an excessive dv/dt is applied to the elements at the time of turn-off, nor a current concentrates in some of the elements, the elements are therefore protected against breakdown, and a large current such as a fault current can be cut off.

## Claims

1. A power converting apparatus comprising:
a MOS gate type semiconductor element section (1),
an on-voltage applying section (2,4,6) for applying an on-voltage between gate and emitter terminals of the MOS gate type semiconductor element section,
an off-voltage applying section (3,5,6) for applying an off-voltage between the gate and emitter terminals of the MOS gate type semiconductor element section (1),
an inductance element (8) connected to the emitter terminal of the MOS gate type semiconductor element section (1);
a current detecting means (11) for detecting a current flowing in the MOS gate type semiconductor element section (1), and
means (15) for applying a variable off-voltage between the gate and the emitter terminals of the MOS gate type semiconductor element section (1) on the basis of a result detected by the current detecting means.

2. The power converting apparatus comprising:
a MOS gate type semiconductor element section (1),
an on-voltage applying section (2,4,6) for applying an on-voltage between gate and emitter terminals of the MOS gate type semiconductor element section,
an off-voltage applying section (3,5,6) for applying an off-voltage between the gate and emitter terminals of the MOS gate type semiconductor element section,
an inductance element (8) connected to the emitter terminal of the MOS gate type semiconductor element section;
a current detecting means (11) for detecting a current flowing in the MOS gate type semiconductor element section;
current determining means (18) for determining a current value equal to or greater than a predetermined value, on the basis of a result detected by the current detecting means; and
means (5a,5b,17a,17b) for varying the gate resistance of the MOS gate type semiconductor element section on the basis of the result obtained by the current detecting means.

3. The power converting apparatus according to claim 1 or 2, wherein said inductance element (8) has a value of 50nH or less.

4. The power converting apparatus according to claim 1 or 2, wherein the inductance element (8) is an annular reactor mounted on the emitter terminal of the MOS gate type semiconductor element section.

5. The power converting apparatus according to claim 1 or 2, wherein
the MOS gate type semiconductor element section (1) has a plurality of MOS gate type semiconductor elements (1a,1b,1c);
the on-voltage applying section (2,4,6) is adapted to apply an on-voltage between gate and emitter terminals of each of said plurality of MOS gate type semiconductor elements; and
the off-voltage applying section (3,5,6) is adapted to apply an off-voltage between the gate and emitter terminals of each of said plurality of MOS gate type semiconductor elements;
further comprising:
a plurality of inductances (8a,8b,8c) connected to the emitter terminals of said plurality of MOS gate type semiconductor elements, for applying different gate voltages to the emitter terminals of the elements, respectively.

6. The power converting apparatus according to claim 5, wherein the off-voltage applying section (3,5,6) comprises means for applying a different off-voltage between the gate and emitter terminals of each of said MOS gate semiconductor elements.

7. The power converting apparatus according to claim 5, wherein the off-voltage applying section comprises:
current detecting means (11) for detecting a current flowing in each of said plurality of MOS gate type semiconductor elements; and
means for applying a variable off-voltage to the MOS gate type semiconductor elements on the basis of a result obtained by the current detecting means.

8. The power converting apparatus according to claim 5, wherein the off-voltage applying section comprises:
current detecting means (11) for detecting currents flowing in said plurality of MOS gate type semiconductor elements, respectively;
current determining means (18) for determining a current value equal to or greater than a predetermined value, on the basis of a result obtained by the current detecting means; and
means for varying gate resistances (5a,5b,17a,17b) of said plurality of MOS gate type semiconductor elements on the basis of the result obtained by the current detecting means.

9. The power converting apparatus according to claim 5, wherein each of the inductances has a value of 50nH or less per element of the MOS gate type semiconductor elements.

10. The power converting apparatus according to claim 5, wherein each of the inductances is an annular reactor mounted on the emitter terminal of an associated one of said plurality of MOS gate type semiconductor elements.

11. A converter system comprising a plurality of power converting apparatuses according to any one of claims 1 to 10, connected in parallel or in series.

## Patentansprüche

1. Leistungswandlervorrichtung mit:
einem Halbleiterelementabschnitt (1) vom MOS-Gate-Typ;
einem AN-Spannungsanlegungsabschnitt (2, 4, 6) zum Anlegen einer AN-Spannung zwischen Gate- und Emitteranschlüssen des Halbleiterelementabschnitts vom MOS-Gate-Typ;
einem AUS-Spannungsanlegungsabschnitt (3, 5, 6) zum Anlegen einer AUS-Spannung zwischen den Gate- und Emitteranschlüssen des Halbleiterelementabschnitts (1) vom MOS-Gate-Typ;
einem Induktanzelement (8), das mit dem Emitteranschluss des Halbleiterelementabschnitts (1) vom MOS-Gate-Typ verbunden ist;
einem Stromdetektionsmittel (11) zum Erfassen eines Stroms, der in dem Halbleiterelementabschnitt (1) vom MOS-Gate-Typ fließt, und
einem Mittel (15) zum Anlegen einer variablen AUS-Spannung zwischen den Gate- und Emitteranschlüssen des Halbleiterelementabschnitts (1) vom MOS-Gate-Typ auf der Grundlage eines Ergebnisses der Erfassung durch das Stromdetektionsmittel.

2. Leistungswandlervorrichtung mit:
einem Halbleiterelementabschnitt (1) vom MOS-Gate-Typ;
einem AN-Spannungsanlegungsabschnitt (2, 4, 6) zum Anlegen einer AN-Spannung zwischen Gate- und Emitteranschlüssen des Halbleiterelementabschnitts (1) vom MOS-Gate-Typ;
einem AUS-Spannunganlegungsabschnitt (3, 5, 6) zum Anlegen einer AUS-Spannung zwischen den Gate- und Emitteranschlüssen des Halbleiterelementabschnitts (1) vom MOS-Gate-Typ;
einem Induktanzelement (8), das mit dem Emitteranschluss des Halbleiterelementabschnitts (1) vom MOS-Gate-Typ verbunden ist;
einem Stromdetektionsmittel (11) zum Erfassen eines Stroms, der in dem Halbleiterelementabschnitt (1) vom MOS-Gate-Typ fließt;
einem Strombestimmungsmittel (18) zum Bestimmen eines Stromwertes gleich oder größer als ein vorgegebener Wert auf der Grundlage des Ergebnisses, das von dem Stromdetektionsmittel erfasst wurde; und
einem Mittel (5a, 5b, 17a, 17b) zum Variieren eines Gatewiderstandes des Halbleiterelementabschnitts (1) vom MOS-Gate-Typ auf der Grundlage des Ergebnisses, das von dem Stromdetektionsmittel erhalten wurde.

3. Leistungswandlervorrichtung nach Anspruch 1 oder 2, bei dem das Induktanzelement (8) einen Wert von 50 nH oder weniger hat.

4. Leistungswandlervorrichtung nach Anspruch 1 oder 2, bei dem das Induktanzelement (8) ein Ringreaktor ist, der an dem Emitteranschluss des Halbleiterelementabschnitts (1) vom MOS-Gate-Typ angebracht ist.

5. Leistungswandlervorrichtung nach Anspruch 1 oder 2, bei der:
der Halbleiterelementabschnitt (1) vom MOS-Gate-Typ eine Mehrzahl von Halbleiterelementen (1a, 1b, 1c) vom MOS-Gate-Typ hat;
der AN-Spannungsanlegungsabschnitt (2, 4, 6) ausgestaltet ist, um eine AN-Spannung zwischen den Gate- und Emitteranschlüssen von jedem der Mehrzahl der Halbleiterelemente vom MOS-Gate-Typ anzulegen; und
der AUS-Spannungsanlegungsabschnitt (3, 5, 6) ausgestaltet ist, um eine AUS-Spannung zwischen den Gate- und Emitteranschlüssen von jedem der Mehrzahl der Halbleiterelemente vom MOS-Gate-Typ anzulegen;
des Weiteren mit:
einer Mehrzahl von Induktanzen (8a, 8b, 8c), die mit den Emitteranschlüssen der Mehrzahl von Halbleiterelementen vom MOS-Gate-Typ verbunden sind, um verschiedene Gatespannungen an die Emitteranschlüsse der jeweiligen Elemente anzulegen.

6. Leistungswandlervorrichtung nach Anspruch 5, bei der der AUS-Spannungsanlegungsabschnitt (3, 5, 6) ein Mittel zum Anlegen einer unterschiedlichen AUS-Spannung zwischen den Gate- und Emitteranschlusses für jeden der Halbleiterelemente des MOS-Gate-Typs umfasst.

7. Leistungswandlervorrichtung nach Anspruch 5, bei der der AUS-Spannungsanlegungsabschnitt umfasst:
ein Stromdetektionsmittel (11) zum Erfassen eines Stromes, der in jedem der Mehrzahl von Halbleiterelementen vom MOS-Gate-Typ fließt;
ein Mittel zum Anlegen einer veränderbaren AUS-Spannung an die Halbleiterelemente vom MOS-Gate-Typ beruhend auf einem Ergebnis, das von dem Stromdetektionsmittel erhalten wurde.

8. Leistungswandlervorrichtung nach Anspruch 5, bei der der AUS-Spannungsanlegungsabschnitt umfasst:
ein Stromdetektionsmittel (11) zum Erfassen von Strömen, die jeweils in der Mehrzahl von Halbleiterelementen vom MOS-Gate-Typ fließen;
ein Strombestimmungsmittel (18) zum Bestimmen eines Stromwertes gleich oder größer als ein vorgegebener Wert auf der Grundlage eines Ergebnisses, das von dem Stromdetektionsmittel erhalten wurde; und
einem Mittel zum Ändern der Gatewiderstände (5a, 5b, 17a, 17b) der Mehrzahl der Halbleiterelemente vom MOS-Gate-Typ auf der Grundlage des Ergebnisses, das von dem Stromdetektionsmittel erhalten wurde.

9. Leistungswandlervorrichtung nach Anspruch 5, bei der jede der Induktanzen für jedes Element der Halbleiterelemente vom MOS-Gate-Typ einen Wert von 50 nH oder weniger hat.

10. Leistungswandlervorrichtung nach Anspruch 5, bei der jede der Induktanzen ein Ringreaktor ist, der an dem Emitteranschluss eines der zugehörigen Halbleiterelemente vom MOS-Gate-Typ angebracht ist.

11. Wandlersystem mit einer Mehrzahl von Leistungswandlervorrichtungen nach einem der Ansprüche 1 bis 10, die parallel oder in Reihe geschaltet sind.

## Revendications

1. Appareil de conversion de puissance, comprenant :
une section élément semi-conducteur de type porte MOS (1) ;
une section application de tension de marche (2, 4, 6) pour appliquer une tension de mise en marche entre les bornes de grille et d'émetteur de la section élément semi-conducteur de type porte MOS ;
une section application de tension d'arrêt (3, 5, 6) pour appliquer une tension de mise à l'arrêt entre les bornes de grille et d'émetteur de la section élément semi-conducteur de type porte MOS (1) ;
un élément d'inductance (8) connecté à la borne d'émetteur de la section élément semi-conducteur de type porte MOS (1) ;
des moyens de détection de courant (11) pour détecter un courant circulant dans la section élément semi-conducteur de type porte MOS (1) ; et
des moyens (15) pour appliquer une tension d'arrêt variable entre les bornes de grille et d'émetteur de la section élément semi-conducteur de type porte MOS (1) en fonction d'un résultat détecté par les moyens de détection de courant.

2. Appareil de conversion de puissance, comprenant :
une section élément semi-conducteur de type porte MOS (1) ;
une section application de tension de marche (2, 4, 6) pour appliquer une tension de mise en marche entre les bornes de grille et d'émetteur de la section élément semi-conducteur de type porte MOS ;
une section application de tension d'arrêt (3, 5, 6) pour appliquer une tension de mise à l'arrêt entre les bornes de grille et d'émetteur de la section élément semi-conducteur de type porte MOS (1) ;
un élément d'inductance (8) connecté à la borne d'émetteur de la section élément semi-conducteur de type porte MOS ;
des moyens de détection de courant (11) pour détecter un courant circulant dans la section élément semi-conducteur de type porte MOS ;
des moyens de détermination de courant (18) pour déterminer une valeur de courant égale ou supérieure à une valeur prédéterminée en fonction d'un résultat détecté par les moyens de détection de courant ; et
des moyens (5a, 5b, 17a, 17b) pour faire varier la résistance de grille de la section élément semi-conducteur de type porte MOS en fonction du résultat obtenu par les moyens de détection de courant.

3. Appareil de conversion de puissance selon la revendication 1 ou 2, dans lequel ledit élément d'inductance (8) a une valeur de 50 nH ou moins.

4. Appareil de conversion de puissance selon la revendication 1 ou 2, dans lequel ledit élément d'inductance (8) est une résistance annulaire montée sur la borne d'émetteur de la section élément semi-conducteur de type porte MOS.

5. Appareil de conversion de puissance selon la revendication 1 ou 2, dans lequel
la section élément semi-conducteur de type porte MOS (1) comporte une pluralité d'éléments semi-conducteurs de type porte MOS (1a, 1b,1c);
la section application de tension de marche (2, 4, 6) est adaptée pour appliquer une tension de mise en marche entre les bornes de grille et d'émetteur de chacun de ladite pluralité d'éléments semi-conducteurs de type porte MOS ; et
la section application de tension d'arrêt (3, 5, 6) est adaptée pour appliquer une tension de mise à l'arrêt entre les bornes de grille et d'émetteur de chacun de ladite pluralité d'éléments semi-conducteurs de type porte MOS ; et
comprenant en outre :
une pluralité d'inductances (8a, 8b, 8c) connectées aux bornes d'émetteur d'éléments respectifs de ladite pluralité d'éléments semi-conducteurs de type porte MOS pour appliquer différentes tensions de grille aux bornes d'émetteur des éléments respectifs.

6. Appareil de conversion de puissance selon la revendication 5, dans lequel la section application de tension d'arrêt (3, 5, 6) comprend des moyens pour appliquer une tension de mise à l'arrêt différente entre les bornes de grille et d'émetteur de chacun desdits éléments semi-conducteurs de type porte MOS.

7. Appareil de conversion de puissance selon la revendication 5, dans lequel la section application de tension d'arrêt comprend :
des moyens de détection de courant (11) pour détecter un courant circulant dans chacun de ladite pluralité d'éléments semi-conducteurs de type porte MOS ; et
des moyens pour appliquer une tension de mise à l'arrêt variable aux éléments semi-conducteurs de type porte MOS en fonction d'un résultat obtenu par les moyens de détection de courant.

8. Appareil de conversion de puissance selon la revendication 5, dans lequel la section application de tension d'arrêt comprend :
des moyens de détection de courant (11) pour détecter des courants circulant dans des éléments respectifs de ladite pluralité d'éléments semi-conducteurs de type porte MOS ;
des moyens de détermination de courant (18) pour déterminer une valeur de courant égale ou supérieure à une valeur prédéterminée en fonction d'un résultat obtenu par les moyens de détection de courant ; et
des moyens (5a, 5b, 17a, 17b) pour faire varier les résistances de grille de ladite pluralité d'éléments semi-conducteurs de type porte MOS en fonction du résultat obtenu par les moyens de détection de courant.

9. Appareil de conversion de puissance selon la revendication 5, dans lequel chacune des inductances a une valeur de 50 nH ou moins par élément de la pluralité d'éléments semi-conducteurs de type porte MOS.

10. Appareil de conversion de puissance selon la revendication 5, dans lequel chacune des inductances est une résistance annulaire montée sur la borne d'émetteur de l'un associé de ladite pluralité d'éléments semi-conducteurs de type porte MOS.

11. Système convertisseur comprenant une pluralité d'appareil de conversion de puissance selon l'une quelconque des revendications 1 à 10, connectés en parallèle ou en série.
